# EUROPEAN PATENT APPLICATION

(11) **EP 2 471 973 A1**
(43) Date of publication of application: **04.07.2012**
(21) Application number: 10812041.1
(22) Date of filing: 30.08.2010
(51) Int. Cl.: C23C 16/507, H01L 31/04

(54) **APPARATUS FOR FORMING DEPOSITED FILM AND METHOD FOR FORMING DEPOSITED FILM**

(30) Priority: 28.08.2009 JP 2009198434
(71) Applicant: Kyocera Corporation, Kyoto-shi, Kyoto 612-8501 (JP)
(72) Inventor: ITO, Norikazu, Higashiomi-shi Shiga 527-8555 (JP); INABA, Shinichiro, Higashiomi-shi Shiga 527-8555 (JP); MATSUI, Hiroshi, Higashiomi-shi Shiga 527-8555 (JP)
(74) Representative: Witte, Weller & Partner
(86) International application number: PCT/JP2010/064692
(87) International publication number: WO 2011/024995

(57) **Abstract**

An apparatus for forming deposited film according to an aspect of the present invention includes: a chamber; a first electrode located in the chamber; and a second electrode located in the chamber with a predetermined spacing from the first electrode, the second electrode including a first supply part supplying a first material gas to a space between the first electrode and the second electrode, a plurality of second supply parts supplying a second material gas to the space, a first supply path connected to the first supply part, through which the first material gas is introduced, and a second supply path connected to the second supply parts, through which the second material gas is introduced, wherein: the second supply path includes a main part with a first inlet through which the second material gas is introduced, and a branch part including a plurality of gas flow paths with a second inlet through which the second material gas is introduced from the main part; a plurality of the second supply parts are connected to each of the plurality of gas flow paths of the branch part; and the main part and the branch part are structured so that the second material gas does not flow into the second supply parts from the first inlet as a straight flow.

## Description

### Technical Field

The present invention relates to an apparatus for forming deposited film and a method for forming deposited film for forming, for example, a deposited film of silicon or the like on a substrate.

### Background Art

The applicant has proposed, as an apparatus capable of depositing a high quality film on a substrate at a high speed, a gas separation plasma chemical vapor deposition (CVD) apparatus in which advantages of the plasma CVD method and thermo-catalytic CVD method are mixed (for example, see Patent Document 1 below).

According to this apparatus, material gases having a low decomposition probability, such as an H₂ gas, can be introduced into a chamber while decomposing and activating H₂ gas through a gas supply path in which a mechanism that increases a decomposition probability, such as a heated catalyzer, is disposed.

This allows the H₂ gas to contribute to the formation of a microcrystalline silicon film without increasing charged particles that degrade the film quality in the plasma CVD method.

Further, material gases having a high decomposition probability, such as an SiH₄ gas, are introduced into the chamber through another gas supply path in which a heated catalyzer is not disposed, which allows the SiH₄ gas to contribute to the formation of a deposited film while suppressing the generation of SiH₂, SiH and Si that degrade the film quality in the thermo-catalytic CVD method.

As a result, the gas separation plasma CVD apparatus is capable of forming a high quality film at a high speed.

### Prior Art Document

### Patent Document

Patent Document 1: Japanese Patent Application Laid-Open No. 2003-173980

### Summary of the Invention

### Problem to be Solved by the Invention

A gas separation plasma CVD apparatus separates and supplies material gases in accordance with a gas decomposition probability, and thus in the formation of a deposited film, it is a challenge to the formation of a deposited film to deposit a film having a uniform film thickness distribution by uniformly supplying a sufficient amount of material gases even at a small flow rate.

For example, in the formation of a microcrystalline silicon film, the flow rate of SiH₄ gas is smaller than the flow rate of H₂ gas, which is 1/10 to 1/200. For this reason, SiH₄ gas is less likely to be supplied uniformly from a plurality of gas supply parts, and the in-plane film thickness distribution of a deposited film is prone to be nonuniform in a large apparatus for forming deposited film having a deposited area exceeding 1 m².

The present invention has been made in view of the above, and an object thereof is to provide an apparatus for forming deposited film and a method for forming deposited film capable of forming a deposited film having a uniform film thickness distribution. In particular, it is aimed to provide an apparatus for forming deposited film and a method for forming deposited film that are effective at forming Si-based thin films used in thin film Si-based solar cells.

### Means to Solve the Problem

An aspect of the present invention relates to an apparatus for forming deposited film including:
a chamber;
a first electrode located in the chamber; and
a second electrode located in the chamber with a predetermined spacing from the first electrode, the second electrode including a first supply part supplying a first material gas to a space between the first electrode and the second electrode, a plurality of second supply parts supplying a second material gas to the space, a first supply path connected to the first supply part, through which the first material gas is introduced, and a second supply path connected to the second supply parts, through which the second material gas is introduced, wherein:
   the second supply path includes a main part with a first inlet through which the second material gas is introduced, and a branch part including a plurality of gas flow paths with a second inlet through which the second material gas is introduced from the main part;
   a plurality of the second supply parts are connected to each of the plurality of gas flow paths of the branch part; and
   the main part and the branch part are structured so that the second material gas does not flow into the second supply parts from the first inlet as a straight flow.

Another aspect of the present invention relates to a method for forming deposited film of forming a deposited film on a substrate disposed between the first electrode and the second electrode with the above-mentioned apparatus for forming deposited film,
wherein the first material gas and the second material gas is supplied between the first electrode and the second electrode to generate a plasma, thereby forming a deposited film on the substrate.

### Effects of the Invention

According to the above-mentioned apparatus for forming deposited film and method for forming deposited film, with the above-mentioned configuration, a material gas having a small flow rate can be supplied uniformly into a chamber from respective supply parts, which enables to form a deposited film having a uniform film thickness distribution on a substrate.

### Brief Description of Drawings

FIG. 1 is a cross-sectional view schematically showing an embodiment of an apparatus for forming deposited film according to the present invention.
FIG. 2 is a view schematically showing the structure of a second supply path in a second electrode used in the embodiment of the apparatus for forming deposited film according to the present invention, which is a cross-sectional view taken along a line II-II of FIG.1.
FIG. 3(a) and FIG. 3(b) are enlarged cross-sectional views schematically showing a positional relationship between a main part and a branch part used in the embodiment of the apparatus for forming deposited film according to an aspect of the present invention.
FIG. 4 is a cross-sectional view schematically showing a modification of the second supply path used in the embodiment of the apparatus for forming deposited film according to the present invention.
FIG. 5 is a cross-sectional view schematically showing a modification of the second supply path used in the embodiment of the apparatus for forming deposited film according to the present invention.
FIG. 6 is a cross-sectional view schematically showing a modification of the second supply path used in the embodiment of the apparatus for forming deposited film according to the present invention.
FIG. 7(a) and FIG. 7(b) are cross-sectional views schematically showing modifications of the second supply path used in the embodiment of the apparatus for forming deposited film according to the present invention.
FIG. 8(a) and FIG. 8(b) are enlarged perspective views schematically showing modifications of the second supply path used in the embodiment of the apparatus for forming deposited film according to the present invention.
FIG. 9 is an enlarged perspective view schematically showing a modification of the second supply path used in the embodiment of the apparatus for forming deposited film according to the present invention.
FIG. 10 is a cross-sectional view schematically showing an embodiment of the apparatus for forming deposited film according to the present invention.
FIG. 11 is a cross-sectional view schematically showing a modification of the second supply path used in the embodiment of the apparatus for forming deposited film according to the present invention.
FIG. 12 is an enlarged cross-sectional view schematically showing a modification of the second supply path used in the embodiment of the apparatus for forming deposited film according to the present invention.
FIG. 13 is a cross-sectional view schematically showing a second supply path used in an apparatus for forming deposited film according to a comparative example.

### Embodiments for Carrying Out the Invention

Hereinafter, embodiments of an apparatus for forming deposited film according to the present invention are described with reference to the drawings.

### <Apparatus for forming deposited film>

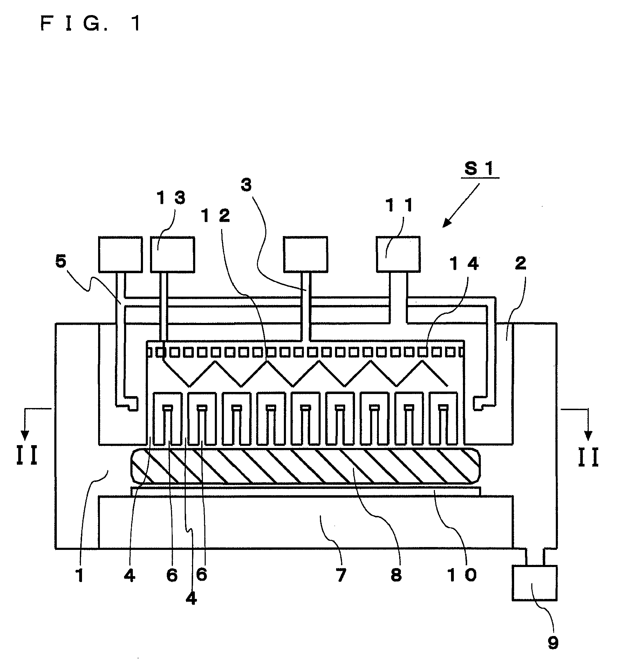

As shown in FIG. 1, an apparatus S1 for forming deposited film includes a chamber 1, a first electrode 7 located in the chamber 1, and a second electrode 2 that is located in the chamber 1 with a predetermined spacing from the first electrode 7 and functions as a shower electrode. Further, a substrate 10 on which a deposited film is formed is disposed between the first electrode 7 and the second electrode 2. It suffices that the substrate 10 is located between the first electrode 7 and the second electrode 2, and the substrate 10 is not limited to be supported on the first electrode 7.

The chamber 1 is a reaction vessel with a reaction space that is defined at least by an upper wall, a peripheral wall and a bottom wall and can be vacuum-sealed. The interior of the chamber 1 is evacuated by a vacuum pump 9. The pressure inside the chamber 1 is adjusted by a pressure regulator (not shown). It is desired to use a dry-system vacuum pump such as a turbo-molecular pump as the vacuum pump 9 for preventing mixture of impurities from an exhaust system into a film formed on the substrate 10. The ultimate vacuum of the chamber 1 is 1 × 10⁻³ Pa or less, and is preferably 1 × 10⁻⁴ Pa or less. The pressure inside the chamber 1 in the film formation is 50 to 7,000 Pa though it varies depending on the type of a film to be formed.

The first electrode 6 has a function as an anode electrode and contains a heater that controls the temperature of the substrate 10. The first electrode 7 also functions as a temperature control mechanism for the substrate 10, and accordingly the substrate 10 is controlled to, for example, 100 to 400°C, and more preferably 150 to 350°C.

Used as the substrate 10 may be a flat plate comprised of a glass substrate or the like, or may be a film comprised of a metal material, resin or the like.

The second electrode 2 is disposed to be opposed to the first electrode 7 and functions as a shower electrode and a cathode electrode. The second electrode 2 includes first supply parts 4 and second supply parts 6 that supply gases introduced through a first supply path 3 and a second supply path 5 into the chamber 1. Those first supply parts 4 and second supply parts 6 are open toward the substrate 10.

A high-frequency power source 11 is connected to the second electrode 2, in which a frequency of approximately 13.56 MHz to 100 MHz can be used. In a case of forming a film to have a large area of 1 m² or more, a frequency of approximately 60 MHz or less is preferably used. Upon application of power to the second electrode 2 from the high-frequency power source 11, a plasma is formed in a space 8 in which a plasma is generated between the second electrode 2 and the substrate 10.

The plurality of first supply parts 4 and the plurality of second supply parts 6 are connected to, through the first supply path 3 and the second supply path 5, a plurality of gas cylinders (not shown) that store different gases, respectively. Basically, the gases introduced through the first supply path 3 and the second supply path 5 are not mixed with each other until they reach the space 8 in which a plasma is generated after passing through the first supply parts 4 and the second supply parts 6, respectively.

The gases supplied to the plurality of first supply parts 4 and the plurality of second supply parts 6 include a first material gas and a second material gas that has a higher decomposition probability compared with the first material gas. The total decomposition rate of gas is defined as e x p (-ΔEa/kTe) × Ng × Ne × ve × σg. Here, ΔEa represents the excitation and activation energy (dissociation energy) of material gas, k represents the Boltzmann constant, Te represents an electron temperature, Ng represents a material gas concentration, Ne represents an electron concentration, ve represents an electron speed, and σg represents the collision cross-section of material gas. In this case, e x p (-ΔEa/kTe) indicates a decomposition probability. Note that e x p (-ΔEa/kTe) × σg is also expressed as σ (Ea) in some cases.

The first material gas is supplied from the first supply parts 4 through the first supply path 3, and the second material gas is supplied from the second supply parts 6 through the second supply path 5. In some cases, the first material gas flowing through the first supply path 3 is divided and a part thereof is caused to flow through the second supply path 5 (mixed with the second material gas), as described below.

The first material gas and the second material gas are appropriately selected in accordance with the type of a deposited film. For example, in a case of forming an Si-based thin film comprised of a-Si:H (hydrogenated amorphous silicon), µc-Si:H (hydrogenated microcrystalline silicon) or the like, a non-Si-based gas and an Si-based gas may be used as the first material gas and the second material gas, respectively. A hydrogen (H₂) gas or the like is used as the non-Si-based gas. A silane (SiH₄) gas, disilane (Si₂H₆) gas, silicon tetrafluoride (SiF₄) gas, silicon hexafluoride (Si₂F₆) gas, dichlorosilane (SiH₂Cl₂) gas or the like is used as the Si-based gas. In a case of introducing a doping gas, for example, a diborane (B₂H₆) gas is used as a p-type doping gas and a phosphine (PH₃) gas is used as an n-type doping gas. Any of the first supply path 3 and the second supply path 5 may be selected as a supply path of the doping gas as desired. However, in a case where a heated catalyzer 12 is provided in the first supply path 3 as described below, the doping gas is desirably introduced through the second supply path 5.

The heated catalyzer 12 connected to a heating power source 13 may be provided in the first supply path 3, and the first material gas is heated and activated by the heated catalyzer 12 heated to approximately 500 to 2,000°C and is also activated in the space 8 in which a plasma is generated. Note that heating means such as a resistive heater may be used in place of the heated catalyzer 12.

The heated catalyzer 12 functions as a heated catalyzer that increases the temperature through heating by causing a current to flow through a medium, to thereby excite and activate (decompose) the gas in contact therewith. At least the surface of the heated catalyzer 12 is comprised of a metal material. This metal material is preferably and desirably pure metal or an alloy material containing at least one of Ta, W, Re, Os, Ir, Nb, Mo, Ru, and Pt that are refractory metal materials. The heated catalyzer 12 is shaped by, for example, forming the above-mentioned metal material into a wire, a plate or a mesh.

The heated catalyzer 12 is preliminarily heated at a temperature equal to or higher than a heating temperature during the film formation for several minutes or longer, before being used in the film formation. This suppresses doping of impurities in the metal material of the heated catalyzer 12 to the film in the film formation.

It is possible to uniformly bring gas into contact with the heated catalyzer 12 by providing a dispersion plate 14 that is comprised of, for example, stainless steel and has a large number of holes upstream of the heated catalyzer 12, which efficiently activates the gas.

The apparatus S1 for forming deposited film, including the above-mentioned configuration accelerates decomposition of the first material gas through heating by the heated catalyzer 12 and further accelerates gas decomposition in the space 8 in which a plasma is generated owing to an increase of the temperature of the first material gas that has not been decomposed or the first material gas recombined after being decomposed. Further, the second material gas is supplied from the second supply parts 6 without coming into contact with the heated catalyzer 12 and is excited and activated in the space 8 in which a plasma is generated. This enables to form a film at a high speed without excessively decomposing the second material gas, which enables to form a high quality thin film.

In particular, a hydrogen gas (first material gas) whose temperature has been increased by the heated catalyzer 12 is supplied to the space 8, and thus reaction of higher-order silane formation is suppressed in the space 8 owing to a gas heating effect.

Here, the reaction of higher-order silane formation is the reaction in which a high-molecular polymer is formed by SiH₂ insertion reaction expressed below and similar SiH₂ insertion reaction thereafter.

1) SiH₄ + SiH₂ → S₁₂H₆

2) Si₂H₆ + SiH₂ → Si₃H₈

SiH₂ is generated together with SiH₃ that is the main component of a film to be formed by collision of SiH₄ with electrons in a plasma. A larger amount of SiH₂ is generated as excitation power of a plasma is increased particularly for increasing a speed of film formation, thereby forming more higher-order silane molecules as well.

The thus generated higher-order silane molecules disturb deposition reaction (film growth reaction) on a surface of a film to be formed and degrades the film quality when adhering to the surface of the film to be formed, or disturbs the film structure and degrades the film quality when being taken into a film.

The reaction of high-order silnane formation has been already recognized as the exothermal reaction. That is, it is three-body reaction which proceeds by discharging the heat generated through reaction to the space. However, if a space (specifically, space mainly containing hydrogen gas) to which heat is to be discharged has been heated by the gas heating effect, the heat of reaction is difficult to be discharged to this space. That is, the reaction of high-order silnane formation being exothermal reaction is difficult to proceed. Accordingly, it is possible to form a high quality silicon film even under conditions of high-speed film formation with large excitation power of a plasma.

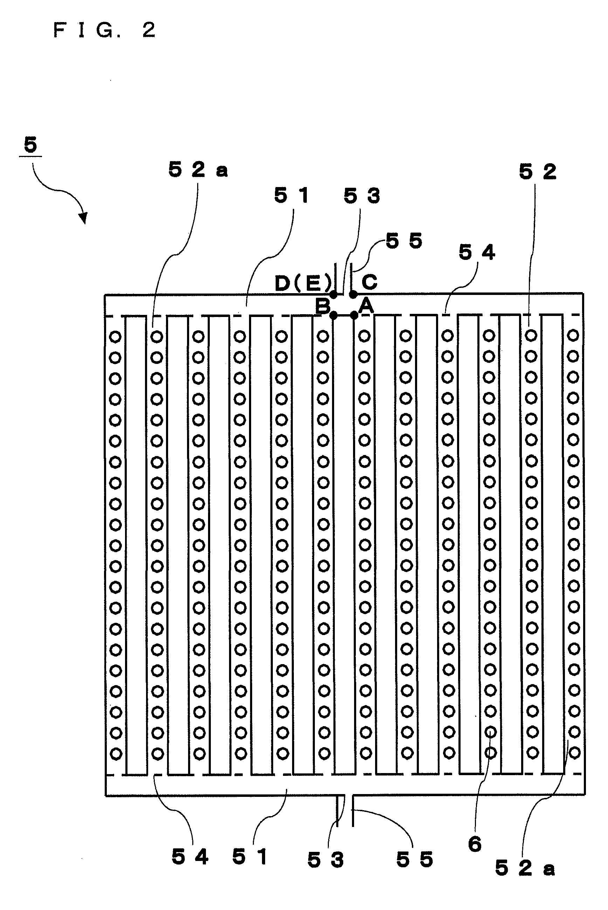

For example, as shown in FIG. 2, the second supply path 5 includes main parts 51 that extend laterally in the upper portion and lower portion in the figure, and a branch part 52 that is connected to the main parts 51 in the upper portion and lower portion and extend perpendicularly in the figure. The branch part 52 includes a plurality of gas flow paths 52a. The second supply parts 6 are not connected to the main parts 51, and the second supply parts 6 are connected only to the gas flow paths 52a of the branch part 52. The second supply path 5 includes first inlets 53 through which the second material gas is introduced into the main parts 51, and the main parts 51 are connected to introduction paths 55 for introducing the second material gas into the main parts 51 through the first inlets 53. Further, the main parts 51 are connected to the gas flow paths 52a of the branch part 52 through second inlets 54 that are connection ports through which the second material gas flows into the branch part 52 from the main parts 51.

Here, the second material gas that passes through the cross section of the first inlet 53 flows into the main part 51 while keeping straightness at a gas flow with a certain spread angle, which is determined by a gas flow speed or the like. A longer inner wall length A-B between the gas paths in the first inlet 53 than an opening length C-D of the introduction path 55 in cross section (in this case, which is equal to an opening length C-E of the first inlet 53 in cross section) allows the gas having straightness to come into contact with the inner wall of the main part having the inner wall length A-B. This reduces the straightness of the second material gas, and accordingly, the second material gas flows laterally along the inner wall of the main part 51 and is uniformly distributed to the respective branch parts 52 without the straight components flowing directly into the second supply parts 6.

The description has been given of the method of bringing the second material gas into contact with the inner wall of the A-B portion that is the inner wall of the main part 51 to reduce the straightness of gas, which is not limited thereto. For example, the inner wall of the main part 51 opposed to the second inlet 54, to which the branch part 52 is not connected, may be used as the inner wall of the main part 51 with which the second material gas is brought into contact, as described below. Alternatively, the case where the second material gas is introduced perpendicularly with respect to the longitudinal direction of the main part 51 has been described for the sake of convenience, which is not limited thereto.

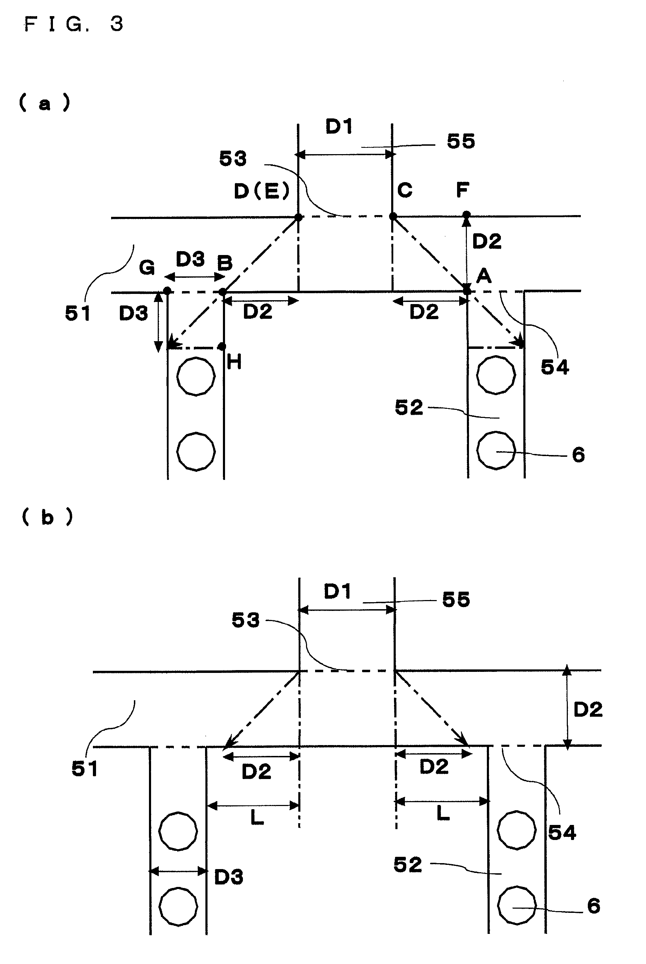

The positional relationship between the introduction path 55 and the branch part 52 is described below with reference to FIG. 3.

As shown in FIG. 3(a), in plan view of the second supply path 5, the opening length C-D of the introduction path 55 in cross section in the first inlet 53 is referred to as D1, the cross-sectional opening length A-F of the main part 51 is referred to as D2, and the opening length B-G of the branch part 52 in cross section is referred to as D3.

The straight components of the gas flowing into the main part 51 from the first inlet 53 may spread toward, for example, an arrow direction shown in FIG. 3(a). However, if an inflow depth B-H of straight components of gas into the branch part 52 is made equal to or smaller than the opening length D3 of the branch part in cross section, an effect of the gas straightness is reduced, which enables to uniformly distribute the second material gas into the respective gas flow paths 52a of the branch part 52. In this case, the inlet of the second supply port 6 is positioned in the area spaced from the second inlet 54 by the opening length D3 of the branch part 52 or more in cross section, and thus the straight components do not flow directly into the second supply parts 6.

As shown in FIG. 3(b), if a distance L between the first inlet 53 and the second inlet 54 (gas flow path 52a of the branch part 52) is equal to or larger than the cross-sectional opening length D2 of the main part 51 in the direction along the longitudinal direction of the main part 51, the inflow depth of the straight components of gas into the branch part 52 is constantly equal to or smaller than the opening length D3 of the branch part 52 in cross section, which enables to distribute the second material gas uniformly to the gas flow paths 52a of the branch part 52.

The description has been given of the simple structure shown in FIG. 3 as an example of the structure of the main part 51 and the branch part 52 in the second supply path 5, which is not limited thereto. It suffices that the plurality of second supply parts 6 are connected to each of the plurality of gas flow paths 52a of the branch part 52, and that the main part 51 and the branch part 52 include the structure in which the second material gas does not flow into the second supply parts 6 from the first inlet 53 as a straight flow.

For example, the structure may be one in which, in one gas flow path of the branch part 52, an inlet of the second supply part 6 connected to the one gas flow path is not positioned on the straight line joining the first inlet 53 and the second inlet 54. Alternatively, in the direction along the longitudinal direction of the main part 51, the distance L between the first inlet 53 and the second inlet 54 is equal to or larger than the cross-sectional opening length D2 of the main part 51.

Next, modifications of the structure of the main part 51 and the branch part 52 are described.

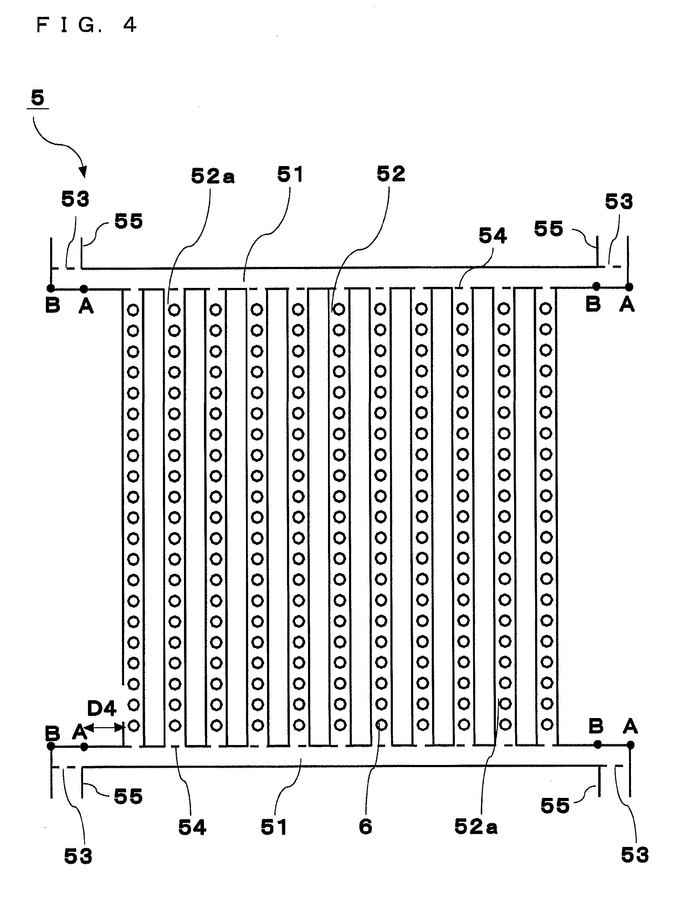

In the modification of FIG. 4 which is shown as the cross-sectional view similar to FIG. 2, the second supply path 5 includes the main parts 51 that extend laterally above and below the branch part 52, and the branch part 52 that is connected to the main parts 51 located thereabove and therebelow and includes the plurality of gas flow paths 52a extending perpendicularly. In this case, the structure is made such that the second supply parts 6 are not connected to the main parts 51, and the second supply parts 6 are connected only to the respective gas flow paths 52a of the branch part 52. The main part 51 is connected to the introduction paths 55 for introducing the second material gas into the main part 51 through the first inlets 53, and is further connected to the branch part 52 through the second inlets 54. In this case, the first inlets 53 are each provided on the side further outside of the gas flow path 52a positioned on the outermost side among the gas flow paths 52a of the branch part 52 connected to the main part 51.

With the above-mentioned configuration of the second supply path 5, the second material gas introduced through the introduction path 55 is brought into contact with the side wall A-B of the main part, which reduces the straightness of gas. This suppresses an inflow of a large amount of gas into the branch part 52 in the vicinity of the first inlet 53, and the gas is distributed uniformly into the respective gas flow paths 52a of the branch part. As a result, the second material gas can be supplied uniformly into the chamber, which enables to form a deposited film with a uniform film thickness on the substrate 10.

Also in this modification, it is possible to distribute the second material gas uniformly to the respective gas flow paths 52a of the branch part 52 by setting a length D4 between the first inlet 53 and the gas flow path 52a positioned at the most edge portion that is connected to the main part 51 to be equal to or larger than the cross-sectional opening length D2 of the main part 51 described above.

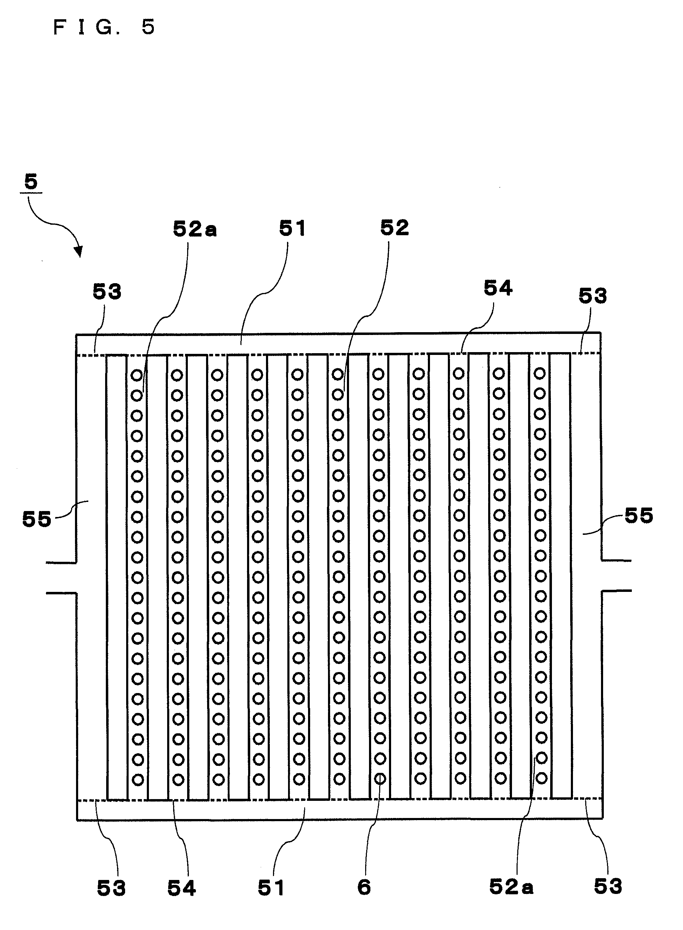

In the modification shown in FIG. 5 that is shown as the cross-sectional view similar to FIG. 2, the second supply path 5 includes the main parts 51 that extend laterally in the upper portion and lower portion of the figure, and the branch part 52 that is connected to the main parts 51 positioned in the upper portion and the lower portion and includes the plurality of gas flow paths 52a extending perpendicularly in the figure. The structure is made such that the second supply parts 6 are not connected to the main parts 51, and the second supply parts 6 are connected only to the respective gas flow paths 52a of the branch part 52. The main parts 51 are connected to the introduction paths 55 for introducing the second material gas into the main parts 51 through the first inlets 53, and are further connected to the branch part 52 through the second inlets 54. In this case, the first inlets 53 are each provided on the side further outside of the gas flow path 52a positioned at the outermost side among the gas flow paths 52a of the branch part 52 connected to the main part 51. In the main part 51 in the upper portion, the first inlets 53 and the second inlets 54 are provided on the lower surface side. In addition, the gas passing through the cross section of the first inlet 53 flows upward and then comes into contact with the side wall of the main part 51 that is opposed to the first inlet 53, where gas straightness is reduced, and then, flows along the longitudinal direction of the main part 51. Then, the second material gas is distributed uniformly to the respective gas flow paths 52a of the branch part 52.

The modification of FIG. 5 shows the case where two main parts 51 are provided, which is not limited thereto, and no problem occurs when only one main part 51 is provided. Further, the introduction path 55 is divided from one pipe into two and connected to the two main parts 51, which is not particularly limited to the above-mentioned configuration. Further, the cross-sectional shapes of the first supply path 3 and the second supply path 5 are not limited, which may be, for example, circular or polygonal.

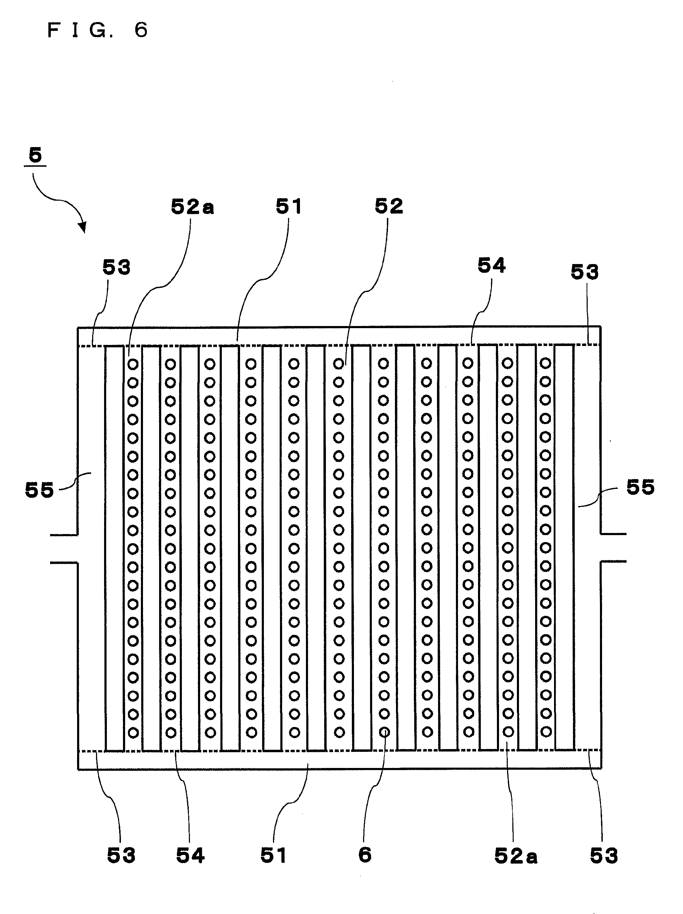

As shown in FIG. 6 that is shown as a cross-sectional view similar to FIG. 2, it is possible to supply the material gas more uniformly into the chamber by gradually increasing the cross-sectional area in the gas flow perpendicular direction (cross-sectional area of a flow path) of the gas flow path 52a of the branch part 52 with increasing distance from the first inlet 53.

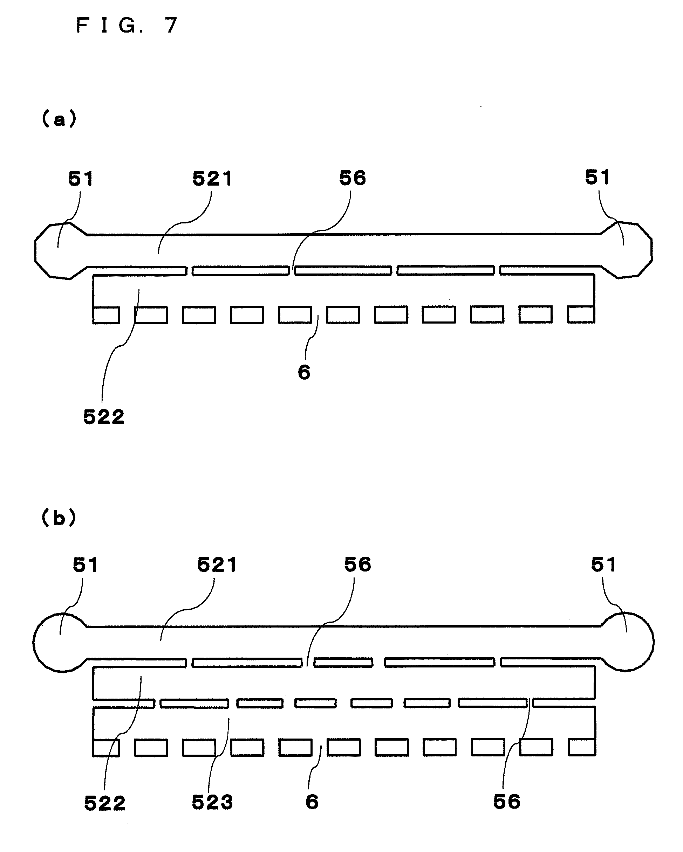

As shown in FIG. 7(a) and FIG. 7(b), the branch part 52 preferably comprises, in its perpendicular direction, a multilayered structure in which one or more buffer spaces serving as buffer parts against the flow rate of the second material gas and a supply space including the second supply parts 6 are combined. For example, in the structure shown in FIG. 7(a), a first branch part 521 serves as the buffer space and a second branch part 522 serves as the supply space. In the structure shown in FIG. 7(b), the first branch part 521 and the second branch part 522 serve as the buffer spaces, and a third branch part 523 serves as the supply space. The respective branch parts are connected to each other through branch part connecting ports 56 (openings through which the second material gas passes). The multilayered structure of the branch part 52 in this manner enables to supply gas uniformly further from the second supply parts 6.

As shown in FIG. 7(a), it is preferable to provide fewer branch part connecting ports 56 than the second supply parts 6. Moreover, the cross-sectional area of the opening of the branch part connecting port 56 smaller than the cross-sectional area of the flow path of the second supply part 6 enables to supply gas uniformly further from the second supply parts 6.

As shown in FIG. 7(b), it is preferable not to provided a plurality of branch part connecting ports 56 to the branch part 52 at equal intervals, but to provide a larger number thereof on the center side than the end side of the branch part 52. Further, if the cross-sectional area of the opening of the branch part connecting port 56 is made to gradually increase toward the center of the branch part 52, gas can be supplied uniformly from the second supply parts 6 in the state in which the second supply parts 6 are provided at equal intervals. This results in the formation of a deposited film having a uniform film thickness distribution.

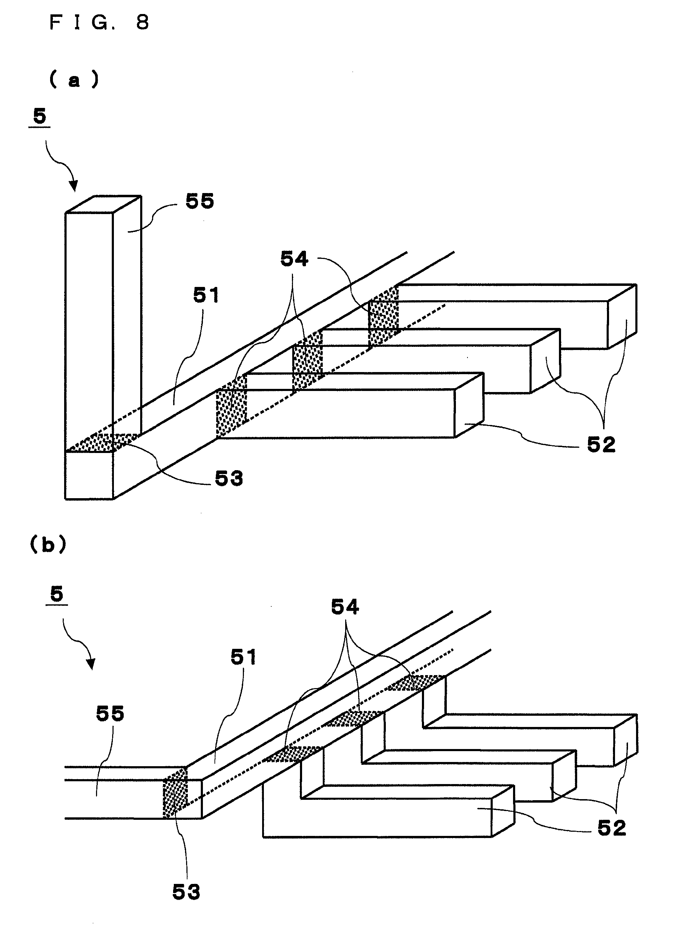

As shown in FIG. 8(a), the main part 51 may be connected to the introduction path 55 extending perpendicularly. The flow direction of the gas passing through the cross section of the first inlet 53 is perpendicular in this case, and the flow direction of the gas passing through the cross section of the second inlet 54 is horizontal. This further relieves an effect of gas straightness on the branch part 52, which allows gas to flow uniformly in a plurality of gas flow paths 52a.

As shown in FIG. 8(b), the second inlets 54 may be provided perpendicularly to the main part 51. For example, the branch part 52 is formed so as to extend downward from the main part 51 and then extend horizontally, whereby an effect of gas straightness is relieved, which enables gas to flow uniformly in the plurality of gas flow paths 52a. The branch part 52 may extend upward from the main part 51.

In a case where a plurality of first inlets 53 are provided, it is possible to supply gas uniformly into the chamber by providing the first inlets 53 at both ends of the main part 51.

It is possible to control the gas flow rate supplied to each of the first inlets 53 by providing a flow rate control mechanism that controls a gas flow rate in the introduction path 55 positioned upstream of the plurality of first inlets 53 provided, which enables to supply gas more uniformly into the chamber.

As the flow rate control mechanism, it is preferable to adjust the conductance of the introduction path 55 positioned upstream of the first inlets 53, and it suffices that a cross section area of the introduction path 55 is adjusted with a valve or mass flowmeter.

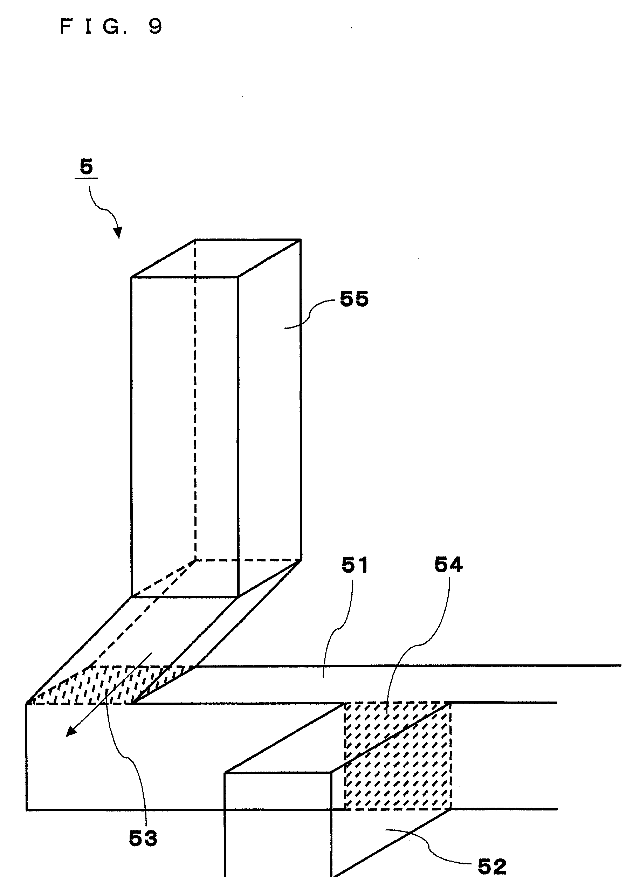

As shown in FIG. 9, the flow rate control mechanism is achieved by adjusting the flow direction of gas toward the first inlet 53, which relieves an effect of gas straightness and can reduce the flow of a large amount of gas through the gas flow paths 52a of the branch part 52 close to the first inlet 53.

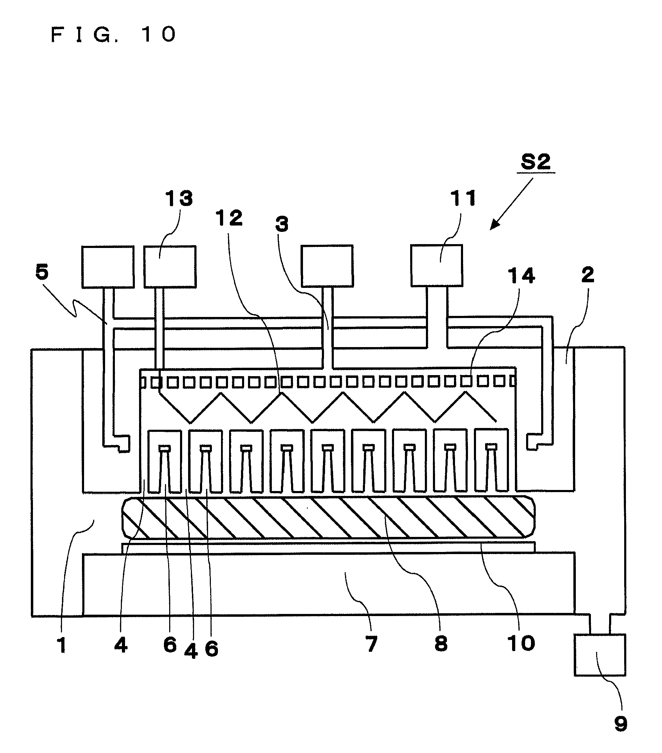

As shown in FIG. 10, in an apparatus S2 for forming deposited film, the cross section of the opening of the second supply part 6 may be increased toward the space 8 in which a plasma is generated. Accordingly, gas is supplied into the chamber 1 so as to be diffused around the second supply parts 6, which enables to supply gas uniformly onto the substrate 10 provided to be opposed to the second supply parts 6. Note that other main configuration is similar to that of FIG. 1 in the apparatus S2 for forming deposited film of FIG. 10, which is not described.

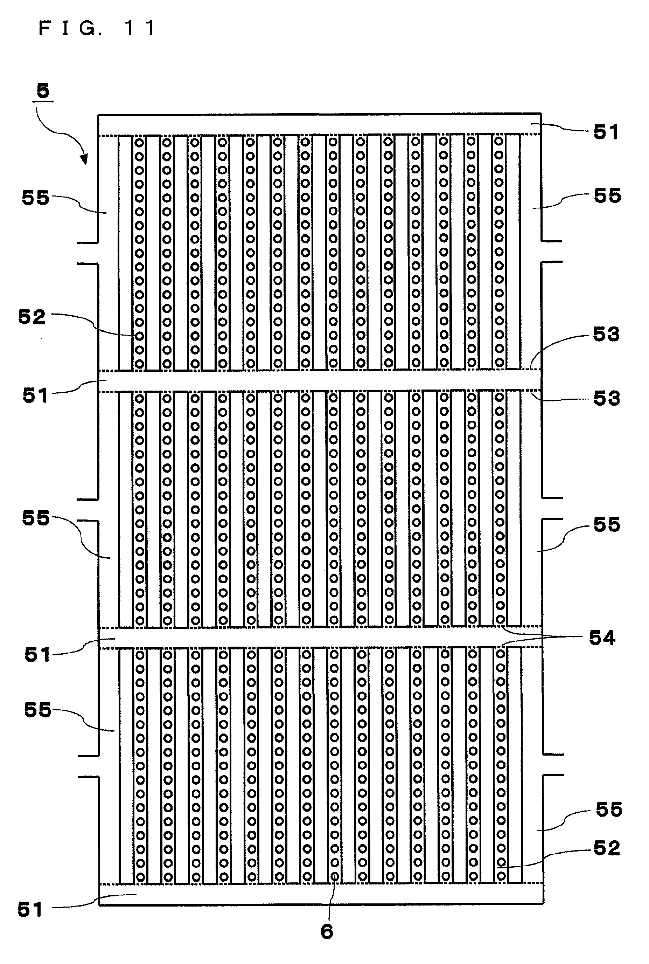

As shown in FIG. 11 that is shown as a cross-sectional view similar to FIG. 2, a plurality of branch parts 52 including a plurality of gas flow paths may be arranged side by side, and different main parts 51 may be connected to both ends of the plurality of branch parts 52. In addition, a plurality of first inlets 53 from which the material gas is introduced to the main parts 51 are each positioned on the side closer to the end side beyond the branch part 52 connected to the end side of the main part. Further, at least two first inlets 53 may be provided to be opposed to each other. Gas straightness is lost also with the above-mentioned configuration, which enables gas to flow uniformly in the plurality of branch parts 52.

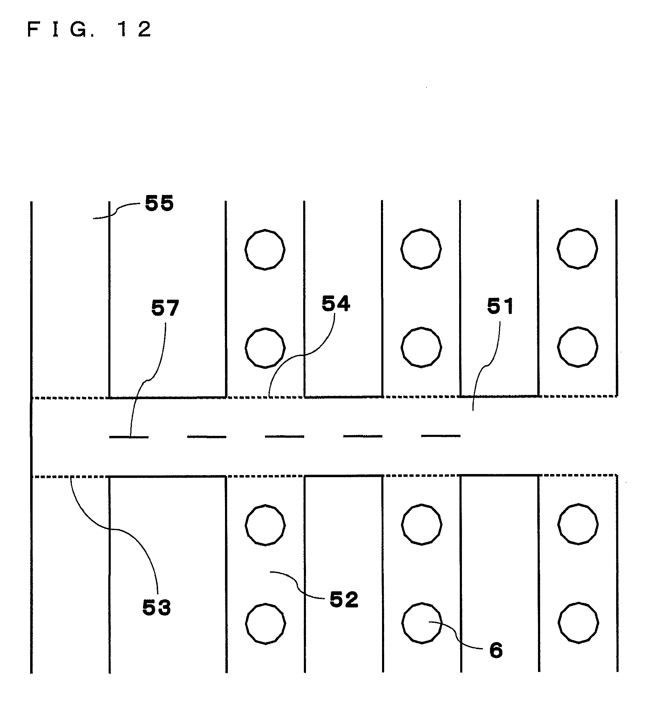

As shown in FIG. 12, by providing a flow control member 57 for changing a direction of a gas flow of the second material gas from the main part 51 to the branch part 52 within the main part 51, gas straightness is lost further, which enables gas to flow uniformly in the plurality of branch parts 52. Also in employing the above-mentioned structure, it is possible to prevent the second material gas from flowing into the second supply parts 6 from the first inlet 53 as a straight flow. On this occasion, the flow control member 57 may be provided only in the vicinity of the first inlet 53.

The first supply parts 4 and the second supply parts 6 may be arranged in various patterns such as lattice pattern and staggered pattern. Alternatively, the number of first supply parts 4 may be different from the number of second supply parts 6. In a case where the gas flow rate of first material gas is different from the gas flow rate of second material gas, for example, if the gas flow rate of first material gas is larger compared with the second material gas, a supply balance is kept by increasing the number of first supply parts 4 than the number of second supply parts 6, which enables to uniformly form a deposited film.

The first supply path 3 and the second supply part 5 may be coupled to a gas controller that controls the flow rate, flow speed, temperature and the like of gas. Alternatively, a buffer space may be provided, so that the gases supplied from the respective cylinders are mixed together in the mixed area, and then the mixed gas is supplied from the first supply parts 4 and the second supply parts 6 after passing through the first supply path 3 and the second supply path 5.

The apparatus for forming deposited film may include a structure in which a plurality of film forming chambers are provided. For example, in a case of forming a thin film solar cell element, it suffices that for example, film forming chambers for forming a p-type film, an i-type film and an n-type film are provided and that at least one film forming chamber includes the above-mentioned structure. For example, productivity can be enhanced by applying the above-mentioned structure to the film forming chamber for forming an i-type film that requires a film having large thickness and high quality. Moreover, it is possible to manufacture a thin film solar cell having high conversion efficiency.

### <Method for forming deposited film>

A method for forming deposited film according to the present embodiment is the method of forming a deposited film on the substrate 10 arranged between the first electrode 7 and the second electrode 2 with the above-mentioned apparatus for forming deposited film, which is **characterized in that** a first material gas and a second material gas are supplied between the first electrode 7 and the second electrode 2 to generate a plasma, thereby forming a deposited film on the substrate 10.

Specifically, for example, the following steps are sequentially performed: the step of causing the first electrode 7 to support the substrate 10; the step of applying high-frequency power to the second electrode 2; and the step of supplying, toward the substrate 10, the first material gas in a state of being activated by the heated catalyzer 12 by the first supply parts 4 and the second material gas by the second supply parts 6, to thereby activate the second material gas in the space 8 in which a plasma is generated between the first electrode 7 and the second electrode 2. The first material gas and the second material gas activated through the above-mentioned steps are mixed together in the space 8 in which a plasma is generated, and the components of the material gases are deposited on the substrate 10. This allows a good quality deposited film to be formed rapidly on the substrate 10.

In the above-mentioned steps, the substrate 10 is transported by a substrate transport mechanism (not shown) or the like and is supported on the first electrode 7. Then, the substrate 10 is fastened on the first electrode 7.

The first material gas is heated by the heated catalyzer 12 in the first supply path 3 and is supplied only from the first supply parts 4, whereby the first material gas whose temperature has been risen by the heated catalyzer 12 is supplied to the space 8 in which a plasma is generated. Accordingly, the reaction of higher-order silane formation in the space 8 in which a plasma is generated is suppressed by a gas heating effect.

In a case of forming a hydrogenated amorphous silicon film, an H₂ gas and an SiH₄ gas are supplied to the first supply path 3 and the second supply path 5, respectively. It suffices that a gas pressure is set to 50 to 700 Pa, an H₂/SiH₄ gas flow rate ratio is set to 2/1 to 40/1, and a high-frequency power density is set to 0.02 to 0.2 W/cm². It suffices that in a case of a thin film solar cell with a pin junction including an i-type amorphous silicon film, the thickness of the i-type amorphous silicon film is formed to be 0.1 to 0.5 µm, and more preferably, 0.15 to 0.3 µm.

In a case of forming a hydrogenated microcrystalline silicon film, an H₂ gas and an SiH₄ gas are supplied to the first supply path 3 and the second supply path 5, respectively. It suffices that a gas pressure is set to 100 to 7,000 Pa, an H₂/SiH₄ gas flow rate ratio is set to 10/1 to 200/1, and a high-frequency power density is set to 0.1 to 1 W/cm². It suffices that in a case of a thin film solar cell with a pin junction including an i-type microcrystalline silicon film, the i-type microcrystalline silicon film has a thickness of 1 to 4 µm, and more preferably, 1.5 to 3 µm, and the degree of crystallization is around 70%.

In the forming method according to the present embodiment, a hydrogen gas (first material gas) whose temperature has been risen by the heated catalyzer 12 is supplied to the space 8 in which a plasma is generated, and thus the reaction of higher-order silane formation in the space 8 is suppressed by a gas heating effect, which enables enhancement of crystallization of a microcrystalline silicon film and high-speed film formation.

In the formation of a hydrogenated microcrystalline silicon film, the flow rate of SiH₄ gas is much smaller than that of H₂ gas compared with the formation of a hydrogenated amorphous silicon film. For this reason, a gas pressure balance cannot be obtained between the first supply parts 4 and the second supply parts 6, and SiH₄ gas is difficult to be supplied uniformly from the respective second supply parts 6, which may result in a nonuniform film thickness distribution. However, the deposition with the apparatus for forming deposited film according to the embodiment reduces the above-mentioned nonuniform film thickness distribution.

The number of second supply parts 6 is made smaller than the number of first supply parts 4, or the cross-sectional area of the opening of the second supply part 6 is made smaller, whereby a gas pressure inside the second supply path 5 can be increased. This allows the SiH₄ gas to be pumped uniformly from the plurality of second supply parts 6.

Further, a part of the H₂ gas (first material gas) supplied to the first supply path 3 may be supplied to the second supply path 5 in a divided manner, which increases a total flow rate of the gases supplied from the second supply parts 6. This increases a gas pressure (total pressure) inside the second supply path 5, whereby the SiH₄ gas is pumped uniformly from the plurality of second supply parts 6.

The present invention is not limited to the embodiment described above, and numerous modifications and variations can be devised without departing from the scope of the invention.

For example, a larger number of second supply parts 6 may be provided on the center side than the end side of each of the gas flow paths 52a of the branch part 52. Alternatively, the cross-sectional of the opening of the second supply part 6 may become larger toward the center portion of each of the gas flow paths 52a of the branch part 52. As a result, gas can be supplied uniformly from the second supply parts 6.

While the embodiment above has described the apparatus for forming deposited film in which electrodes and the substrate 10 are provide horizontally, a deposited film having a uniform film thickness distribution can be formed also by using an apparatus for forming deposited film in which electrodes and the substrate 10 are provided perpendicularly.

While the embodiment above has described the example in which the heated catalyzer 12 is used, a plurality of material gases may be introduced into the first supply path 3 and the second supply path 5 in a divided manner without using the heated catalyzer 12.

In a plurality of supply parts among the first supply parts 4 and second supply parts 6 provided in the second electrode 2, for example, the cross-sectional area of the flow path may be configured to be larger in the gas outlets so as to provide the first supply parts 4 including the space in which a hollow cathode discharge is generated and the second supply parts 6 in which a hollow cathode discharge is not generated or the small discharge is generated. Here, the hollow cathode discharge is one type of glow discharges, which refers to a discharge in which electrons move back and forth by electrostatic confinement, and the energy of the electrons on this occasion is used for plasma generation, which considerably increases the plasma density.

The above-mentioned first supply parts 4 of the second electrode 2 are shaped in, for example, a tapered manner or a stepwise manner such that the cross-sectional area of the plane perpendicular to the axis in the depth direction becomes smaller as the depth thereof increases, that is, such that the cross-sectional area becomes smaller with increasing distance from the first electrode 7. This generates a hollow cathode discharge at a position with an appropriate depth within the recess in accordance with the magnitude of the ambient pressure in the discharge space. The first material gas is capable of accelerating decomposition of the first material gas by a high-density plasma of the hollow cathode discharge in the first supply part 4.

This further accelerates activation of the first material gas as well as reduces excessive decomposition of the second material gas. In a case where a part of the first material gas supplied to the first supply path 3 is supplied to the second supply path 5 in a divided manner, even when an amount of the first material gas that passes through the first supply path 3 is small, it is possible to further accelerate decomposition of the first material gas by heating by the heated catalyzer 12 and a high-density plasma of the hollow cathode discharge. This leads to the formation of a high quality deposited film on the substrate 10 at a sufficiently high speed.

In the case where the heated catalyzer 12 is provided in the first supply path 3 in the formation of an SiC-based wide gap film of, for example, amorphous silicon carbide (a-SiC), an H₂ gas is supplied to the first supply path 3 and a silane (SiH₄) gas and a CH₄ gas are supplied to the second supply path 5 irrespective of the presence/absence of the first supply part 4 including a space in which a hollow cathode discharge is generated. Alternatively, in a case where the heated catalyzer 12 is not provided in the first supply path 3 and the first supply part 4 including a space in which a hollow cathode discharge is generated is provided, an H₂ gas and a CH₄ gas are supplied to the first supply path 3 and a silane (SiH₄) gas is supplied to the second supply path 5.

The deposition film formation conditions in this case may be made such that a gas pressure is set to 100 to 700 Pa and a high-frequency power density is set to 0.01 to 0.1 W/cm². An SiC-based wide gap film is used as a window layer of a solar cell on a light incidence side. For example, in a case of a thin film solar cell with a pin junction including a p-type amorphous silicon carbide film, the thickness of the p-type amorphous silicon carbide film may be formed to 0.005 to 0.03 µm, and preferably, 0.01 to 0.02 µm. It is possible to use an SiC-based wide gap film as a photoactive layer (i-type layer).

In the formation of an SiGe-based narrow gap film of amorphous silicon germanium (a-SiGe) or the like, when the heated catalyzer 12 is provided in the first supply path 3, an H₂ gas is supplied to the first supply path 3 and Ge-based gases such as a silane (SiH₄) gas and a german (GeH₄) gas are supplied to the second supply path 5 irrespective of the presence/absence of the first supply part 4 that includes a space in which a hollow cathode discharge is generated.

In a case where the heated catalyzer 12 is not provided in the first supply path 3 but the first supply part 4 that includes a space in which a hollow cathode discharge is generated is provided, an H₂ gas and an SiH₄ gas are supplied to the first supply path 3 and a Ge-based gas is supplied to the second supply path 5.

The deposited film formation conditions in this case may be made such that a gas pressure is set to 100 to 700 Pa and a high-frequency power density is set to 0.01 to 0.2 W/cm². An SiGe-based narrow gap film is used for absorbing light having a long-wavelength that cannot be absorbed by an Si film. In a case of a thin film solar cell with an [a-Si/a-SiGe/µc-Si] type triple junction including an i-type amorphous silicon germanium film, the thickness of the i-type amorphous silicon germanium film may be formed to 0.1 to 0.5 µm, and preferably, 0.15 to 0.3 µm. In a case of a thin film solar cell with an [a-Si/µc-Si/µc-SiGe] type triple junction including an i-type microcrystalline silicon germanium film, the thickness of the i-type microcrystalline silicon germanium film may be formed to 1 to 4 µm, and preferably, 1.5 to 3 µm.

A thin film solar cell formed by the above-mentioned method is formed of a high quality film at a high speed, which enables to manufacture a solar cell having enhanced productivity and high conversion efficiency. Examples of such a thin film solar cell include: one including a tandem structure in which a semiconductor comprised of an amorphous silicon film and a semiconductor comprised of a microcrystalline silicon film are laminated from a light-receiving surface side; and one including a triple structure in which a semiconductor comprised of an amorphous silicon film, a semiconductor comprised of an amorphous silicon germanium film and a semiconductor comprised of a microcrystalline silicon film, or a semiconductor comprised of an amorphous silicon film, a semiconductor comprised of a microcrystalline silicon film and a semiconductor comprised of a microcrystalline silicon germanium film are laminated. It suffices that at least one of the above-mentioned semiconductors is formed by the method described above.

### Example

Description is given below of an example in which the present invention is further embodied.

As shown in FIG. 1, the apparatus S1 for forming deposited film includes the chamber 1, the first electrode 7 disposed in the lower portion of the chamber 1, the substrate 10 disposed on the first electrode 7, and the second electrode 2 disposed to be opposed to the first electrode 7. A plurality of first supply parts 4 and a plurality of second supply parts are provided in the second electrode 2 and are connected to the first supply path 3 and the second supply path 5, respectively, and the heated catalyzer 12 is provided in the first supply path 3.

As shown in FIG. 5, the second supply path 5 includes two main parts 51 extending laterally and the branch part 52 that connect the two main parts 51 and includes a plurality of gas flow paths 52a extending vertically in plan view, and reduces the straightness of a gas flow on the inner wall surfaces of the main parts 51 on the side opposed to the second inlet 54 where a flow direction of the gas passing through the cross section of the first inlet 53 and a flow direction of the gas passing through the cross section of the second inlet 54 are opposite to each other by 180 degrees.

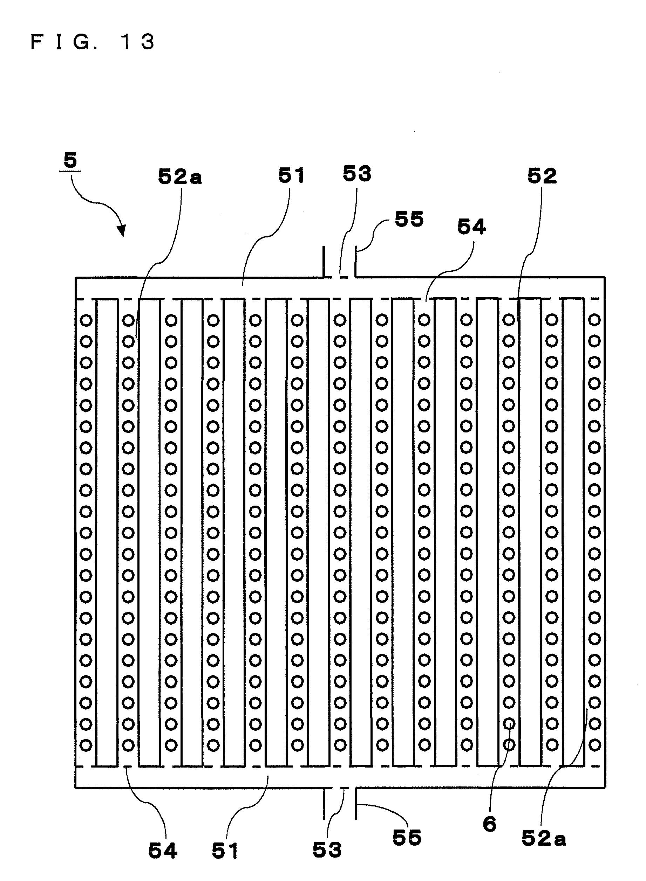

As shown in FIG. 13, the second supply path 5 of the apparatus for forming deposited film according to a comparative example includes two main parts 51 extending laterally and the branch part 52 that connect the two main parts 51 to each other and includes a plurality of gas flow paths 52a extending vertically in plan view, and has a structure in which the material gas introduced from the first inlet 53 flows into the gas flow paths 52a of the branch part 52 while keeping the straightness thereof.

Then, an i-type microcrystalline silicon film was formed on the substrate 10 with the apparatus S1 for forming deposited film. Various setting conditions for forming an i-type microcrystalline silicon film in this case were made such that a gas pressure of the chamber was 800 Pa and the heating temperature of the substrate was 190°C. In addition, the supply amount of SiH₄ gas introduced into the chamber was 3.94 × 10⁻² Pa·m³/s (25 sccm), and a supply amount of H₂ gas was 1.57 Pa·m³/s (1,000 sccm).

Then, the nonuniformity of thickness of an i-type microcrystalline silicon film formed on a glass substrate of 25 cm × 25 cm was evaluated. The in-plane film thickness distribution of a deposited film is expressed such that nonuniformity of film thickness distribution = ± (T_{Max} - T_{Min}) / (T_{Max} + T_{Min}) × 100(%) where T_{Max} represents the largest film thickness and T_{Min} represents the smallest film thickness.

The nonuniformity of film thickness distribution in a case where the apparatus for forming deposited film according to the comparative example was used was ±20.47%, whereas the nonuniformity of film thickness distribution in a case where the apparatus for forming deposited film according to the present example was used was significantly improved, which was ±7.79%

It was observed from the film thickness distribution according to the comparative example that the i-type microcrystalline silicon film had a larger thickness on the line of the center branch part located in the vicinity of the first inlet 53 and had a smaller thickness toward both ends thereof. Meanwhile, it was observed from the film thickness distribution in the case of using the apparatus for forming deposited film according to the present embodiment that the i-type microcrystalline silicon film had a uniform thickness almost entirely.

### Description of Reference Numbers

- 1:: chamber
- 2:: second electrode
- 3:: first supply path
- 4:: first supply part
- 5:: second supply path
- 51:: main part
- 52:: branch part
- 53:: first inlet
- 54:: second inlet
- 55:: introduction path
- 56:: branch part connecting port
- 57:: flow control member
- 6:: second supply part
- 7:: first electrode
- 8:: space
- 10:: substrate
- 12:: heated catalyzer

## Claims

1. An apparatus for forming deposited film, comprising:
a chamber;
a first electrode located in the chamber; and
a second electrode located in the chamber with a predetermined spacing from the first electrode, the second electrode including a first supply part supplying a first material gas to a space between the first electrode and the second electrode, a plurality of second supply parts supplying a second material gas to the space, a first supply path connected to the first supply part, through which the first material gas is introduced, and a second supply path connected to the second supply parts, through which the second material gas is introduced, wherein:
the second supply path includes a main part with a first inlet through which the second material gas is introduced, and a branch part including a plurality of gas flow paths with a second inlet through which the second material gas is introduced from the main part;
a plurality of the second supply parts are connected to each of the plurality of gas flow paths of the branch part; and
the main part and the branch part are structured so that the second material gas does not flow into the second supply parts from the first inlet as a straight flow.

2. The apparatus for forming deposited film according to claim 1, wherein the structure in which the second material gas dose not flow into the second supply parts from the first inlet as a straight flow is a structure in which, in one of the gas flow paths in the branch part, an inlet of the second supply part connected to the one gas flow path is not located on a straight line joining the first inlet and the second inlet.

3. The apparatus for forming deposited film according to claim 1, wherein the structure in which the second material gas does not flow into the second supply parts from the first inlet as a straight flow is a structure in which a distance between the first inlet and the second inlet in a longitudinal direction of the main part is equal to or larger than a length of an opening of the main part in cross section.

4. The apparatus for forming deposited film according to claim 1, wherein the structure in which the second material gas does not flow into the second supply parts from the first inlet as a straight flow is a structure in which a flow control member changing a direction of a gas flow of the second material gas from the main part to the branch part is provided in the main part.

5. The apparatus for forming deposited film according to any one of claims 1 to 4, wherein a plurality of the branch parts are arranged side by side, and the main parts different from each other are respectively connected to both ends of the plurality of branch parts.

6. The apparatus for forming deposited film according to any one of claims 1 to 5, wherein a heated catalyzer is provided in the first supply path.

7. The apparatus for forming deposited film according to any one of claims 1 to 6, wherein a cross-sectional area of a flow path is increased at an outlet of the first supply part so that a hollow cathode discharge is generated.

8. The apparatus for forming deposited film according to any one of claims 1 to 7, wherein the gas flow path of the branch part has a larger cross-sectional area with increasing distance from the first inlet.

9. The apparatus for forming deposited film according to any one of claims 1 to 8, wherein the branch part includes a buffer space that serves as a buffer part against a flow speed of the second material gas and includes a plurality of openings through which the second material gas passes.

10. The apparatus for forming deposited film according to claim 9, wherein the number of the openings of the buffer space is smaller than the number of the second supply parts.

11. The apparatus for forming deposited film according to claim 9 or 10, wherein cross-sectional areas of the openings of the buffer space are smaller than cross-sectional areas of flow paths of the second supply parts.

12. The apparatus for forming deposited film according to any one of claims 9 to 11, wherein a larger number of the openings of the buffer space are provided on the center side than both end sides of the branch part in plan view of the branch part.

13. The apparatus for forming deposited film according to any one of claims 1 to 12, wherein a cross-sectional area of an opening of the gas flow path becomes wider toward the gas flow path located at the center of the branch part in plan view of the branch part.

14. A method for forming deposited film of forming a deposited film on a substrate disposed between the first electrode and the second electrode with the apparatus for forming deposited film according to any one of claims 1 to 13,
wherein the first material gas and the second material gas is supplied between the first electrode and the second electrode to generate a plasma, thereby forming a deposited film on the substrate.
